# EUROPEAN PATENT APPLICATION

(11) **EP 4 843 701 A1**
(43) Date of publication of application: **25.11.2026**
(21) Application number: 25188317.9
(22) Date of filing: 09.07.2025
(51) Int. Cl.: B23P 15/26, B21D 51/00, H10W 40/47, F16L 41/00, F28F 3/12, B23K 37/04, H05K 7/20

(54) **LIQUID DISPENSER AND MANUFACTURING METHOD THEREOF**

(30) Priority: 19.05.2025 US 202519211463
(71) Applicant: Cooler Master Co., Ltd., Taipei City 114065 (TW)
(72) Inventor: Weng, Sheng-Yang, 114065 Taipei City (TW); Kuo, Yu-Chen, 114065 Taipei City (TW)
(74) Representative: Grünecker Patent- und Rechtsanwälte PartG mbB

(57) **Abstract**

A method for manufacturing a liquid dispenser includes: forming a partial rectangular tube by bending a first steel plate (202) to have a U-shaped cross-section; installing quick connectors (210) into a plurality of dispensing holes (208) that are formed in a second steel plate (204); welding the second steel plate (204) to the first steel plate (202) to form a rectangular manifold (220); securing the manifold (220) into a jig (250) so that a receiving portion of the jig (250) is in thermal contact with the manifold (220) at a position located between the dispensing holes (208) and end portions of the manifold (220); and welding a liquid inlet adapter (232) and a liquid outlet adapter (234) at the respective opposite end portions of the manifold (220).

## Description

### TECHNICAL FIELD

The present disclosure relates to a liquid dispenser and a manufacturing method thereof, particularly a liquid dispenser suitable for the liquid cooling system of a server and a manufacturing method thereof.

### BACKGROUND

The demand for server computing has expanded as technology has advanced rapidly.. To minimize the heat during server operations, liquid cooling systems are employed to cool the various heat-generating electronic components. These electronic components are spread across multiple chassis within the server, requiring the installation of distribution pipes on the server rack to ensure the efficient delivery of cooling liquid.

However, while manufacturing of distribution pipes, the precision of the pipes is sometime compromised due to variable temperatures in the manufacturing environment, requiring repeated processing to ensure the pipes fit the specified dimensions. As a result, there is a critical need for research and development efforts to develop a distribution pipe and improve manufacturing method that eliminate the need for repeated processing, lowering manufacturing costs. Additionally, R&D personnel are focusing on minimizing processing and welding costs while maintaining that the inner wall of the square tube smoothness. The smoothness minimizes fluid flow resistance, assures constant fluid movement, enhances heat dissipation performance, and improves cleanliness.

### SUMMARY

In general terms, this disclosure is directed to Liquid Dispenser and Manufacturing Method thereof. In some embodiments, and by non-limiting example, the present disclosure provides a newly developed liquid dispenser and a novel manufacturing method that enhances heat dissipation efficiency while reducing manufacturing costs.

The invention is as defined in the appended claims. An aspect of the present disclosure provides a method for manufacturing a liquid dispenser. The method includes forming a partial rectangular tube by bending a first steel plate to have a U-shaped cross-section, installing quick connectors into a plurality of dispensing holes that are formed in a second steel plate, welding the second steel plate to the first steel plate to form a rectangular manifold, securing the manifold into a jig so that a receiving portion of the jig is in thermal contact with the manifold at a position located between the dispensing holes and end portions of the manifold, and welding a liquid inlet adapter and a liquid outlet adapter at the respective opposite end portions of the manifold.

In one embodiment, the first steel plate has a thickness in the range of 2 mm to 5 mm.

In one embodiment, the second steel plate has a thickness in the range of 8 mm to 13 mm.

In one embodiment, the dispensing hole extends along a direction in which the thickness of the second steel plate is measured.

In one embodiment, the dispensing hole penetrates the second steel plate.

In one embodiment, the quick connectors are arranged in a staggered pattern.

In one embodiment, drilling the dispensing holes is performed by a Computer Numerical Control (CNC) drilling machine.

In one embodiment, the inlet adapter and the outlet adapter are welded at the opposite ends of the manifold by tungsten inert gas (ITG) welding or laser welding.

In one embodiment, the receiving portion is a recessed channel located at a middle portion of the jig and extending between the welding positions.

This summary is provided to introduce a selection of concepts in a simplified form that are further described below in the Detailed Description. This summary is not intended to identify key features or essential features of the claimed subject matter, nor is it intended to be used to limit the scope of the claimed subject matter.

### BRIEF DESCRIPTION OF THE DRAWINGS

FIG. 1 is a flowchart illustrating a method for manufacturing a liquid dispenser according to an embodiment of the present invention.
FIG. 2 illustrates perspective views of a first steel plate and a second steel plate according to an embodiment of the present invention.
FIG. 3 illustrates cross-sectional views taken along the horizontal axis of the first steel plate and the second steel plate from FIG. 2.
FIG.4 illustrates a perspective view of the first steel plate following its shaping through a bending process.
FIG. 5 illustrates a perspective view of the second steel plate having a plurality of dispensing holes formed via a drilling process.
FIG. 6 illustrates a perspective view of the second steel plate having a plurality of quick connectors installed.
FIG. 7 illustrates a perspective view of a manifold.
FIGS. 8-10 illustrate a schematic diagram of manufacturing process used to further process the manifold into a finished liquid dispenser.

### DETAILED DESCRIPTION

Various embodiments will be described in detail with reference to the drawings, wherein like reference numerals represent like parts and assemblies throughout the several views. Reference to various embodiments does not limit the scope of the claims attached hereto. Additionally, any examples set forth in this specification are not intended to be limiting and merely set forth some of the many possible embodiments for the appended claims.

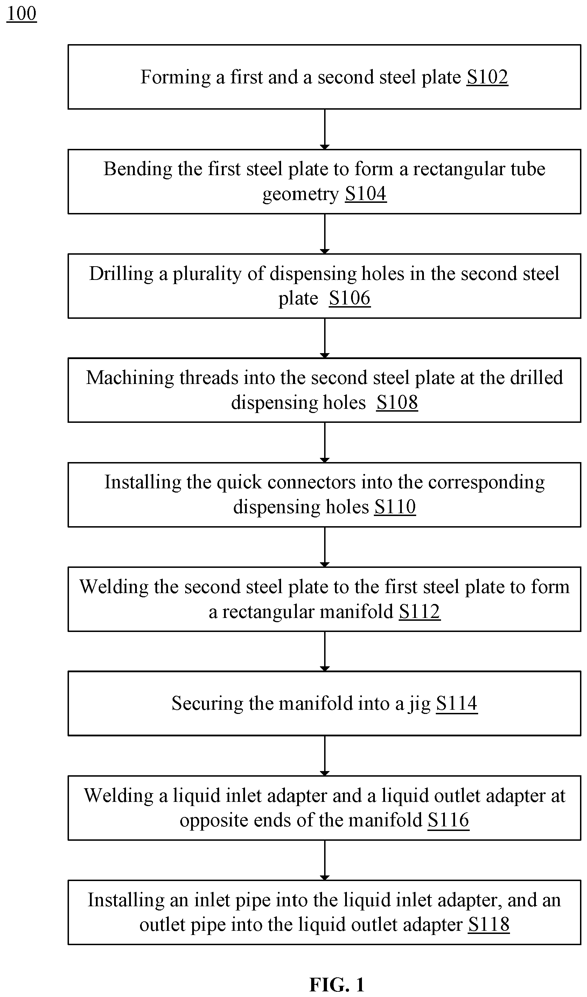

FIG. 1 is a flowchart illustrating an example system 100 for manufacturing a liquid dispenser according to an embodiment of the present invention. As an example illustrated in FIG. 1, the system 100 includes the following steps: Step S102, Forming a first and a second steel plate; Step S104, Bending the first steel plate to form a rectangular tube geometry; Step 106, Drilling a plurality of dispensing holes in the second steel plate; Step 108, Machining threads into the second steel plate at the drilled dispensing holes for coupling with the quick connectors; Step 110, Installing the quick connectors into the corresponding dispensing holes; Step 112, Welding the second steel plate to the first steel plate to form a rectangular manifold; Step 114, Securing the manifold into a jig; Step 116, Welding a liquid inlet adapter and a liquid outlet adapter at opposite ends of the manifold, respectively; Step 118, Placing an inlet pipe into the liquid inlet adapter, and an outlet pipe into the liquid outlet adapter. Other embodiments include more, fewer, or different steps from the example illustrated in FIG. 1.

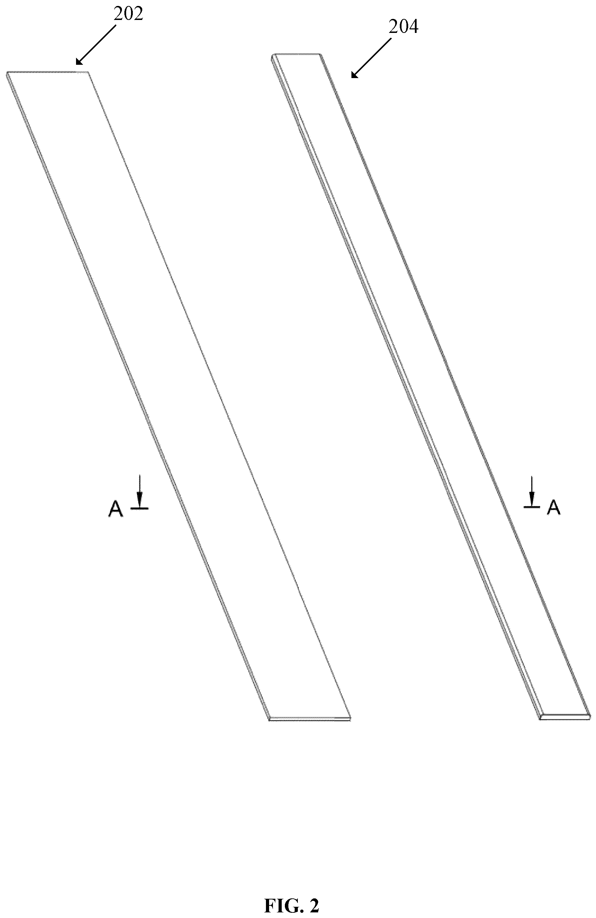

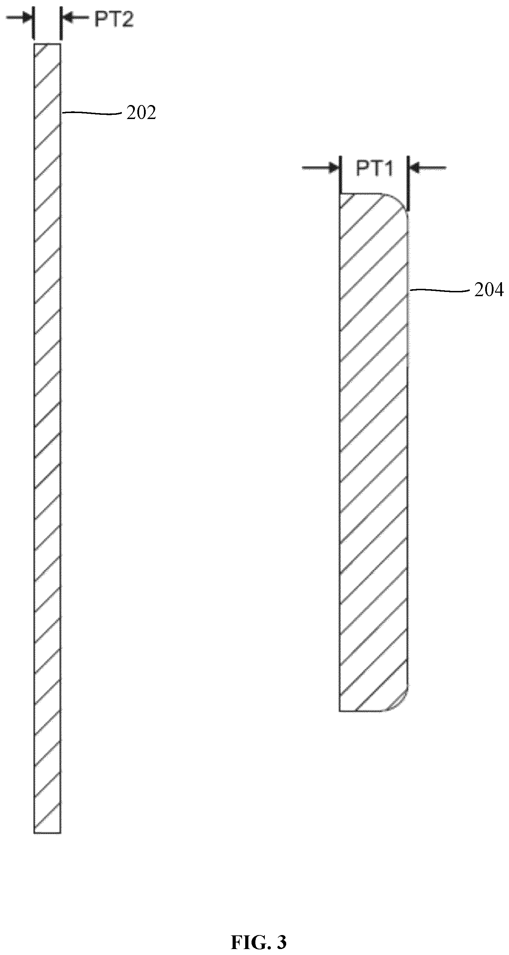

Referring to FIGS. 2 and 3 along with FIG. 1. FIG. 2 illustrates perspective views of a first steel plate and a second steel plate according to an embodiment of the present invention. FIG. 3 illustrates cross-sectional views taken along A-A of the first steel plate and the second steel plate from FIG. 2.

In one embodiment of the liquid dispenser manufacturing process, Step 102 involves forming two steel plates of distinct thicknesses to meet specific structural and functional requirements. For example, the first steel plate 202 has a predetermined thickness PT2, which falls within the range of 2 mm to 5 mm. The thickness selection of the first steel plate 202 needs to meet a balance between flexibility for forming and sufficient strength for structural integrity.

On the other hand, the second steel plate 204 has a predetermined thickness PT1 that is thicker than the first steel plate 202, ranging from 8 mm to 13 mm. The increased thickness is essential for areas of the liquid dispenser that require enhanced robustness, such as points of connection where threaded quick connectors are attached. The thicker plate ensures that there is adequate material to securely support these connectors and withstand the mechanical stresses that may be imposed during operation.

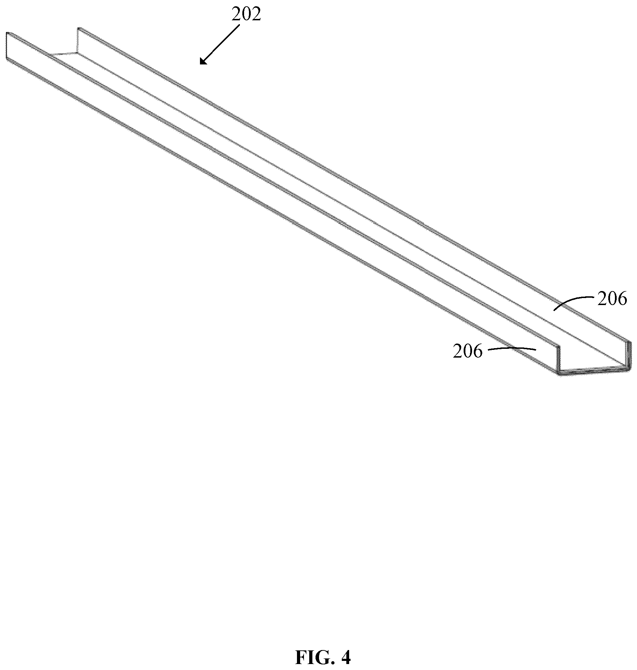

Referring to FIG. 4 along with FIG. 1. FIG. 4 illustrates a perspective view of the first steel plate following its shaping through a bending process. As an example illustrated in FIG. 4, the first steel plate 202 has been bent to form a rectangular tube geometry.

In one embodiment of the liquid dispenser manufacturing process, Step 104 is performed to bend the first steel plate 202, forming two folded edges 206. For example, the edges may be bent at a 90-degree angle relative to the main body of the first steel plate 202. As illustrated in FIG. 4, the bends are positioned symmetrically along the horizontal axis of the plate, with each folded edge 206 located on opposite sides to form a U-shaped cross-section. The bent first steel plate 202 is subsequently used in further assembly steps.

In one embodiment, Press Brake Bending is performed at Step 104 by placing the first steel plate 202 between a punch and a die, wherein the punch presses the steel plate into the die to form a portion of the rectangular tube geometry. However, the embodiment is not limited thereto. In other embodiments, Air Bending, V-Bending, Heat Bending, or any other suitable bending process may be used at Step 104, depending on material thickness, required precision, or equipment availability.

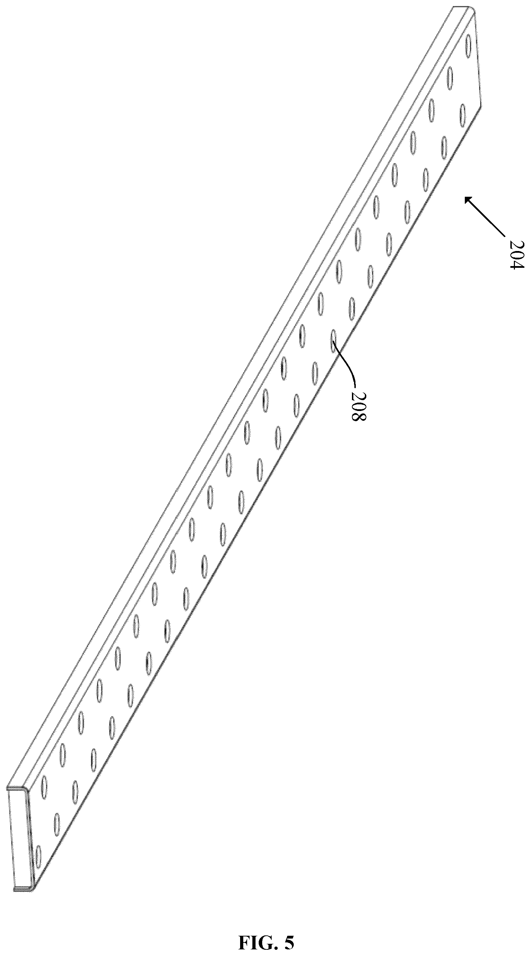

Referring to FIG. 5 along with FIG. 1. FIG. 5 illustrates a perspective view of the second steel plate having a plurality of dispensing holes formed via a drilling process. As an example illustrated in FIG. 5, the second steel plate 204 has been drilled to include a plurality of dispensing holes 208.

In one embodiment of the liquid dispenser manufacturing process, Step 106 is performed to drill a plurality of dispensing holes 208 that penetrate the second steel plate 204. For example, at Step 106, the dispensing holes 208 are drilled vertically from the top surface of the second steel plate 204 while the plate 204 is positioned horizontally. In one embodiment, the dispensing holes 208 are arranged in two rows in a staggered pattern. However, the embodiment is not limited thereto. In other embodiments, the dispensing holes can be arranged in other patterns such as a linear pattern, a circular array, or any other configuration suitable for the intended design or functional requirements.

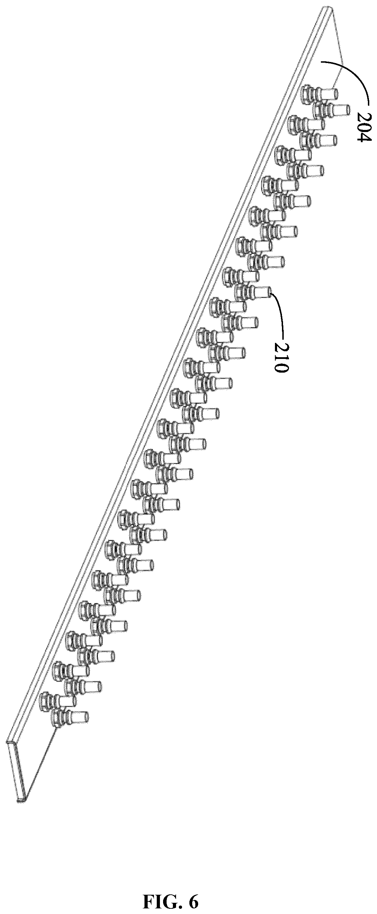

In one embodiment, after being drilled, the dispensing holes 208 extend vertically through the horizontally oriented second steel plate 204. Since the depth of each dispensing hole 208 is substantially the same as the thickness of the second steel plate 204, each dispensing hole 208 is deep enough to meet the installation requirements of a quick connector (as shown in FIG. 6). The dispensing holes 208 are specifically designed to accommodate the structural and mounting needs of the quick connector, leading to a stable and secure attachment to the second steel plate 204.

In one embodiment, a Computer Numerical Control (CNC) drilling machine is utilized for the drilling process at Step 106. During this process, high-speed drill bits are used, and cutting fluid is applied to lower heat and ensure clean hole formation. With the high precision and repeatability of CNC drilling, it can support complex drilling patterns, such as staggered or circular arrays. However, the embodiment is not limited thereto. In other embodiments, Magnetic Drilling Press or other suitable technique can be applied. In one embodiment, a fine process is performed subsequently to improve the dimensional accuracy of the dispensing holes 208.

In one embodiment of the liquid dispenser manufacturing process, Step 108 is performed for making threads into the second steel plate 204 at the drilled dispensing holes 208 to couple with the quick connectors. For example, the threads could be machined using a tapping tool or a thread cutting die to ensure a secure and precise fit for the quick connectors, leading to a tight seal and proper alignment during assembly.

Referring to FIG. 6 along with FIG. 1. FIG. 6 illustrates a perspective view of the second steel plate having a plurality of quick connectors installed. As an example illustrated in FIG. 6, a plurality of quick connectors 210 are installed into the second steel plate 204.

In one embodiment, the quick connectors 210 are mechanical devices that provide quick and secure connections between fluid or gas transfer lines without the use of sophisticated tools or complex procedures. The quick connectors 210 can be screwed into the second steel plate 204 at the drilled dispensing holes (as shown in FIG. 5), establishing a tight seal that prevents leaks and ensures a robust and reliable connection. The quick connectors 210 are made of durable materials such as stainless steel or brass to endure high pressures and harsh conditions.

In one embodiment of the liquid dispenser manufacturing process, Step 110 is performed to install the quick connectors 210 into the corresponding dispensing holes. For example, the quick connectors 210 are screwed into the dispensing holes along the threads. The depth of each dispensing hole is sufficient to fully accommodate the quick connector 210, avoiding the need for an adapter. In one embodiment, the quick connectors 210 are arranged in two rows in a staggered pattern. However, the embodiments are not limited thereto. In some embodiments, the quick connectors 210 can be arranged in other patterns, such as a linear pattern, a circular array, or any other configuration corresponding to the patterns of the dispensing holes.

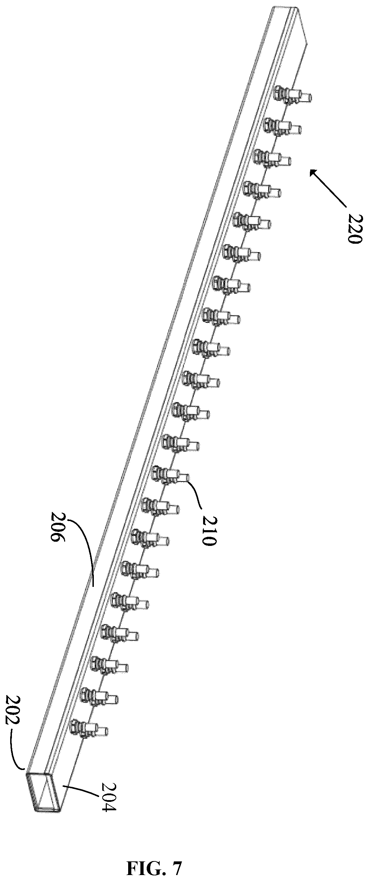

Referring to FIG. 7 along with FIG. 1. FIG. 7 illustrates a perspective view of a manifold. As an example illustrated in FIG. 7, the manifold 220 is formed after Step 112. In one embodiment of the liquid dispenser manufacturing process, Step 112 is performed to weld the second steel plate 204 to the first steel plate 202 to form the rectangular manifold 220. The folded edges 206 formed in Step 104 become sidewalls of the manifold 220.

In one embodiment, the welding process in Step 112 uses the Metal Inert Gas (MIG) welding technique, which is efficient and provides the strong and clean welds for steel components. The MIG welding technique employs a continuously feeding wire and an inert gas that flows around the weld pool to shield it from contamination. This method not only ensures a robust and durable joint between the steel plates but also provides a faster welding speed compared to other techniques, enhancing overall manufacturing productivity. However, the embodiment is not limited thereto. In other embodiments, other suitable welding techniques such as Tungsten Inert Gas (TIG) welding or spot welding are used in accordance with the specific requirements such as the thickness of the plates, desired strength of the weld, and production efficiency. In one embodiment, a cleaning process may be applied after Step 112 to remove residues such as lubricants left by a previously performed CNC process and welding process.

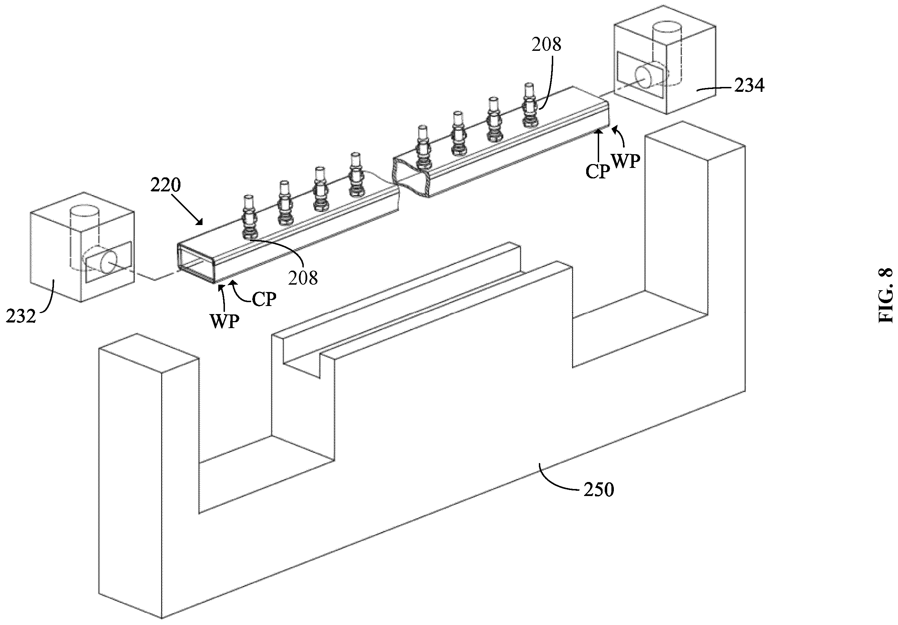

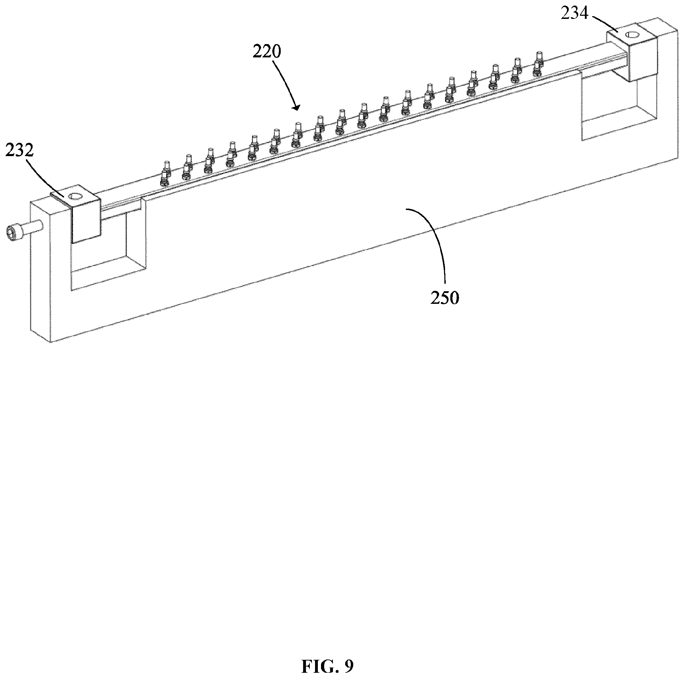

Referring to FIGS. 8-10 along with FIG. 1. FIGS. 8-10 illustrate a schematic diagram of manufacturing process used to further process the manifold into a finished liquid dispenser. As an example illustrated in FIGS. 8 and 9, a jig 250 is used to secure the manifold 220, allowing an inlet adapter 232 and an outlet adapter 234 to be respectively welded at welding positions WP of the manifold 220.

In one embodiment of the liquid dispenser manufacturing process, Step 114 is performed to secure the manifold 220 into a jig so that a receiving portion of the jig is in thermal contact with the manifold. For example, the receiving portion of the jig is at a position located between the dispensing holes and end portions of the manifold. Welding positions WP are positioned at the end portions of the manifold 220. In one embodiment, the receiving portion is a recessed channel located at a middle portion of the jig 250 and extending between the welding positions CP.

In one embodiment, the jig 250 is configured to absorb and transmit heat generated at the welding position portions WP during subsequent welding steps, as the manifold 220 is secured to the jig 250 at the contact point CP located between the dispensing holes and the welding positions. Accordingly, the heat generated at the welding position portions WP is prevented from being transmitted to the dispensing holes 208, maintaining the accuracy of the processing on the dispensing holes 208.

In one embodiment of the liquid dispenser manufacturing process, Step 116 is performed to weld a liquid inlet adapter 232 and a liquid outlet adapter 234 at opposite ends of the manifold 220, respectively. In one embodiment, tungsten inert gas (TIG) welding or laser welding is used in Step 116 to achieve precise and reliable joints. Following the welding process, both the inlet adapter 232 and the outlet adapter 234 are in fluid communication with the interior of the manifold 220.

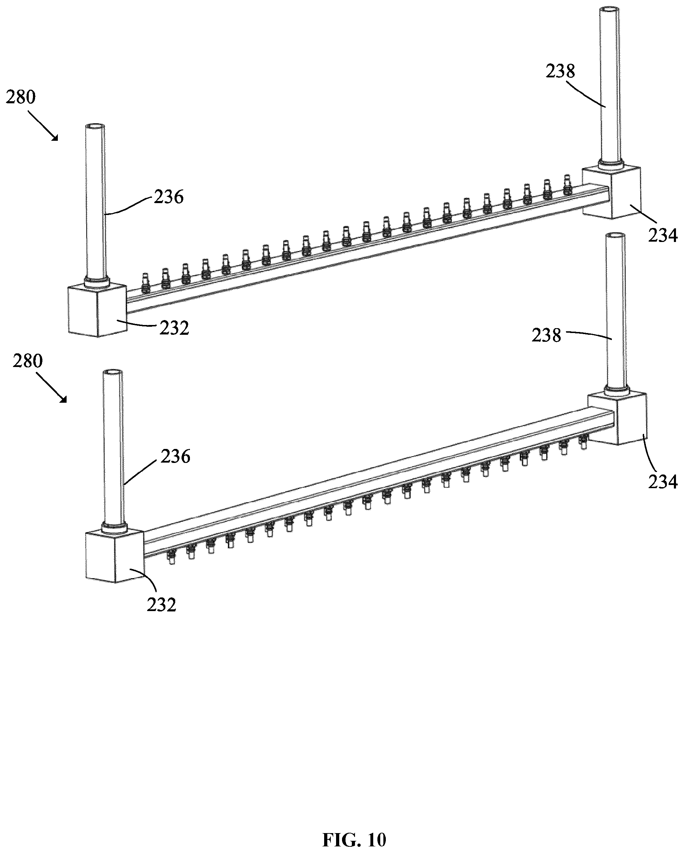

In one embodiment of the liquid dispenser manufacturing process, Step 118 is performed to install an inlet pipe 236 into the liquid inlet adapter 232, and an outlet pipe 238 into the liquid outlet adapter 234. In one embodiment, both the inlet pipe 236 and the outlet pipe 238 are mounted on the same side as the quick connector 210, as illustrated in the upper liquid dispenser 280 of FIG. 10. In another embodiment, the inlet and outlet pipes are positioned on the opposite side of the quick connector 210, as shown in the lower liquid dispenser 280 of FIG. 10.

The inlet pipe 236 serves as a conduit for supplying liquid into the manifold 220, while the outlet pipe 238 directs the liquid from the manifold to downstream components or dispensing outlets. In one embodiment, the pipes are connected to the adapters via threaded engagement, press-fit connection, the using of O-rings, or other secure coupling methods to ensure leak-proof fluid communication. Proper alignment and sealing are verified during installation to maintain the integrity of the fluid path and support reliable operation of the liquid dispenser.

By following the above steps, the liquid dispenser 280 is completed. In one embodiment, a simplified cleaning process is performed after Step 118 to clean the liquid dispenser. The simplified cleaning process requires fewer steps and resources compared to earlier cleaning process after Step 112 since no mechanical processing occurs in Steps 114-118.

The completed liquid dispenser 280 can be mounted onto the rack (not shown) of a server. The working fluid flowing through the inlet pipe 236 is distributed by the manifold 220 to the quick connectors 210, runs through the server chassis, absorbs heat generated by the electronic components inside, exits through the outlet pipe 238, and then completes the heat exchange process. This system is suitable for liquid cooling systems in servers or any other similar electronic devices.

The liquid dispenser 280 produced through the aforementioned steps utilizes both initial and refined processing to make dispensing holes 208 with high precision. Further, the welding of the inlet adapter 232 and outlet adapter 234 is taken place at the welding position portions WP that are located further away from the dispensing holes 232. Therefore, the precision of the dispensing holes 232 is preserved after welding, avoiding the need for additional precision processing and thereby lowering manufacturing time and costs for the liquid dispenser 280.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure. Of course, the disclosed embodiments are merely exemplary embodiments and that various modifications can be made without departing from the spirit and scope of the disclosure. Further, it should be understood that various aspects of the embodiment are not mutually exclusive of each other and can be combined as desired by a person of ordinary skill in the art as a matter of design choices.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A method for manufacturing a liquid dispenser (280), comprising:
forming a partial rectangular tube by bending a first steel plate (202) to have a U-shaped cross-section;
installing quick connectors (210) into a plurality of dispensing holes (208) that are formed in a second steel plate (204);
welding the second steel plate (204) to the first steel plate (202) to form a rectangular manifold (220);
securing the manifold (220) into a jig (250) so that a receiving portion of the jig (250) is in thermal contact with the manifold (220) at a position located between the dispensing holes (208) and end portions of the manifold (220); and
welding a liquid inlet adapter (232) and a liquid outlet adapter (234) at the respective opposite end portions of the manifold (220).

2. The method of claim 1, wherein the first steel plate (202) has a thickness (PT2) in the range of 2 mm to 5 mm.

3. The method of claim 1 or 2, wherein the second steel plate (204) has a thickness (PT1) in the range of 8 mm to 13 mm.

4. The method of claim 3, wherein the dispensing hole (208) extends along a direction in which the thickness of the second steel plate (204) is measured.

5. The method of one of claims 1 to 4, wherein the dispensing hole (208) penetrates the second steel plate (204).

6. The method of claim 3, wherein each dispensing hole (208) has a depth substantially equal to the thickness of the second steel plate (204).

7. The method of one of claims 1 to 6, wherein the quick connectors (210) are arranged in a staggered pattern.

8. The method of one of claims 1 to 7, wherein drilling the dispensing holes (208) is performed by a Computer Numerical Control (CNC) drilling machine.

9. The method of one of claims 1 to 8, wherein the inlet adapter (232) and the outlet adapter (234) are welded at the opposite ends of the manifold (220) by tungsten inert gas (ITG) welding or laser welding.

10. The method of one of claims 1 to 9, wherein the receiving portion is a recessed channel located at a middle portion of the jig (250) and extending between the welding positions (WP).

11. A liquid dispenser (280) for a liquid cooling system formed by a manufacturing process comprising:
forming a partial rectangular tube by bending a first steel plate (202) to have a U-shaped cross-section;
installing quick connectors (210) into a plurality of dispensing holes (208) that are formed in a second steel plate (204);
welding the second steel plate (204) to the first steel plate (202) to form a rectangular manifold (220);
securing the manifold (220) into a jig (250) so that a receiving portion of the jig (250) is in thermal contact with the manifold (220) at a position located between the dispensing holes (208) and end portions of the manifold (220); and
welding a liquid inlet adapter (232) and a liquid outlet adapter (234) at the respective opposite end portions of the manifold (220).

12. The liquid dispenser (280) of claim 11, wherein the thickness (PT2) of the first steel plate (202) is in the range of 2 mm to 5 mm.

13. The liquid dispenser (280) of claim 11 or 12, wherein the thickness (PT1) of the second steel plate (204) is in the range of 8 mm to 13 mm.

14. The liquid dispenser (280) of claim 13, wherein the dispensing hole (208) extends along a direction in which the thickness of the second steel plate (204) is measured.

15. The liquid dispenser (280) of one of claims 11 to 14, wherein the dispensing hole (208) penetrates the second steel plate (204).

16. The liquid dispenser (280) of claim 13, wherein each dispensing hole (208) has a depth substantially equal to the thickness of the second steel plate (204).

17. The liquid dispenser (280) of one of claims 11 to 16, wherein the quick connectors (210) are arranged in a staggered pattern.

18. The liquid dispenser (280) of one of claims 11 to 17, wherein the dispensing holes (208) are drilled by a Computer Numerical Control (CNC) drilling machine.

19. The liquid dispenser (280) of one of claims 11 to 18, wherein the inlet adapter (232) and the outlet adapter (234) are welded to the opposite ends of the manifold (220) by tungsten inert gas (TIG) welding or laser welding.

20. The liquid dispenser (280) of one of claims 11 to 19, wherein the receiving portion is a recessed channel located at a middle portion of the jig (250) and extending between the welding positions (WP).
